# EUROPÄISCHE PATENTANMELDUNG

(11) **EP 2 264 761 A2**
(43) Veröffentlichungstag der Anmeldung: **22.12.2010**
(21) Anmeldenummer: 10004376.9
(22) Anmeldetag: 24.04.2010
(51) Int. Cl.: H01L 25/07, H01L 23/538, H01L 23/049, H01L 23/00

(54) **Verfahren zur Herstellung eines Leistungshalbleitermoduls und Leistungshalbleitermodul mit einer Verbindungseinrichtung**

(30) Priorität: 09.06.2009 DE 102009024385
(71) Anmelder: SEMIKRON Elektronik GmbH & Co. KG, 90431 Nürnberg (DE)
(72) Erfinder: Beckedahl, Peter, 90522 Oberasback (DE); Knebel, Markus, 90587 Tuchenbach (DE); Stockmeier, Thomas, 91054 Erlangen (DE)

(57) **Zusammenfassung**

Die Erfindung betrifft ein Verfahren sowie ein damit hergestelltes Leistungshalbleitermodul mit einem Substrat, einer Verbindungseinrichtung und mit Lastanschlusselementen, wobei auf einer Leiterbahn des Substrats Leistungshalbleiterbauelementen angeordnet und mittels der Verbindungseinrichtung mit einem Lastanschlusselement verbunden ist. Weiterhin weist das Leistungshalbleitermodul Hilfskontaktanschlussflächen auf, die mit einer externen Leiterplatte verbindbar sind, Der wesentliche Herstellungsschritt hierbei ist das gleichzeitige oder sequenzielles stoffschlüssiges Verbinden jeweiliger erster Kontaktflächen der ersten Leiterbahnen mit mindestens einer zweiten Kontaktfläche eines Leistungshalbleiterbauelements und mindestens einer dritten Kontaktfläche eines Lastanschlusselements; Anschließend wird der Verbund aus mindestens einem Leistungshalbleiterbauelement einer Verbindungseinrichtung und Lastanschlusselementen zu einem Gehäuse des Leistungshalbleitermoduls angeordnet

## Beschreibung

Die Erfindung beschreibt ein Verfahren zur Herstellung eines Leistungshalbleitermoduls und Leistungshalbleitermodul mit einer Verbindungseinrichtung, die ausgebildet ist als ein Folienverbund aus mindestens zwei elektrisch leitenden Schichten mit jeweils einer dazwischen angeordneten isolierenden Schicht.

Aus der DE 10 2006 027 482 A1 ist grundsätzlich ein Leistungshalbleitermodul mit einem Substrat und hierauf schaltungsgerecht angeordneten Halbleiterbauelementen und mit einer Verbindungseinrichtung bekannt. Diese besteht aus einem Folienverbund aus zwei elektrisch leitenden Schichten mit einer dazwischen angeordneten isolierenden Schicht, wobei mindestens eine leitende Schicht, diejenige der Lastanschlüsse in sich strukturiert ist und somit Leiterbahnen ausbildet. Diese leitende Schicht bildet im Randbereich selbst Laststrom führende Kontakteinrichtung zur reversiblen Verbindung mit einer externen Zuleitung aus. Hierzu weist die Kontakteinrichtung entweder ein Federelement mit einem Widerlager im Gehäuse oder eine direkt auf die Kontakteinrichtung wirkende Feststellschraube auf.

Nachteilig an diesen Ausgestaltungen ist allerdings, dass diese Ausbildungen der externen Verbindung in ihrer Stromtragfähigkeit begrenzt sind. Weiterhin gestatten diese Ausgestaltung mit Feststellschraube nur eine begrenzte mechanische Stabilität bei der Ausbildung der Verbindung.

Der vorliegenden Erfindung liegt die Aufgabe zu Grunde ein Verfahren zur Herstellung eines Leistungshalbleitermoduls und ein zugehöriges Leistungshalbleitermodul mit einer Verbindungseinrichtung vorzustellen, das einem einheitlichen Fertigungsprozess zugänglich ist, mechanisch stabile Lastanschlusselemente aufweist und Anforderungen bezüglich Luft- und Kriechstrecken gemäß IEC 61287 erfüllt.

Diese Aufgabe wird gelöst durch ein Verfahren gemäß Anspruch 1 und ein Leistungshalbleitermodul gemäß Anspruch 5, wobei spezielle Ausgestaltungen in den jeweiligen abhängigen Ansprüchen genannt sind.

Die Grundlage des erfindungsgemäßen Verfahrens zur Herstellung eines Leistungshalbleitermoduls wie auch das Leistungshalbleitermodul selbst gehen aus von einem auf einer Kühleinrichtung anordenbarem und hiergegen elektrisch isoliertem Substrat. Dieses Substrat weist auf seiner dem Inneren des Leistungshalbleitermoduls zugewandten Seite eine Mehrzahl von Leitbahnen und hierauf angeordneten Leistungshalbleiterbauelementen auf. Diese Leistungshalbleiterbauelemente werden miteinander oder auch mit Leiterbahn des Substrats mittels einer Verbindungseinrichtung schaltungsgerecht verbunden.

Diese Verbindungseinrichtung wiederum ist ausgebildet aus einer Schichtfolge mit einer ersten elektrisch leitenden strukturierten Metallfolie, einer elektrisch isolierenden Folie und einer zweiten elektrisch leitenden strukturierten Metallfolie. Hierbei bilden die jeweiligen Strukturierungen erste und zweite Leiterbahnen aus den jeweiligen Metallfolien, die ihrerseits die oben genannten schaltungsgerechten Verbindungen ausbilden.

Weiterhin weist das erfindungsgemäße Leistungshalbleitermodul eine Mehrzahl von Lastanschlusselementen zur externen Verbindung der üblichen Lastpotentiale eines Leistungshalbleitermoduls auf. Ebenso weist das Leistungshalbleitermodul Hilfsanschlusselemente zur externen Verbindung von beispielhaft Steuer- und / oder Sensorpotentialen auf. Diese externen Verbindungen werden mittels Hilfskontaktanschlussflächen der zweiten Leitbahnen der Verbindungseinrichtung ausgebildet.

Das erfindungsgemäße Verfahren zur Herstellung eines derartigen Leistungshalbleitermodul ist gekennzeichnet durch die folgenden wesentlichen Schritte:
- Bereitstellung des Substrats und der Verbindungseinrichtung; vorteilhafterweise ist die Verbindungseinrichtung derart ausgebildet, dass die isolierende Folie der Verbindungseinrichtung alle ersten Leiterbahnen in Richtung vom Substrat zum Rand der Folie hin derart überragt, dass zu zweiten Leiterbahnen der zweiten Folie die bis zu oder nahe an diesem Rand reichen ausreichend Abstand ist, um Luft- und Kriechstrecken zur elektrischen Sicherheit einzuhalten;
- Gleichzeitiges oder sequenzielles stoffschlüssiges Verbinden jeweiliger erster Kontaktflächen der ersten Leiterbahnen mit mindestens einer zweiten Kontaktfläche eines Leistungshalbleiterbauelements und mindestens einer dritten Kontaktfläche eines Lastanschlusselements; dies kann bevorzugt mittels eines Drucksinterprozesses erfolgen, der alle genannten Verbindungen in einem Prozessschritt ausbildet; Es kann auch vorteilhaft sein die Lastanschlusselement als flächige gerade Metallformkörper mit jeweils einer vorgesehenen Sollbiegestelle auszubilden.
- Anordnen des Verbunds aus mindestens einem Leistungshalbleiterbauelement einer Verbindungseinrichtung und Lastanschlusselementen zu dem Gehäuse des Leistungshalbleitermoduls. Hierbei ist es vorteilhaft, wenn ein jeweiliger Abschnitt der Verbindungseinrichtung auf dem die Kontaktflächen mit den Lastanschlusselementen angeordnet sind bei der Anordnung zu dem Gehäuse senkrecht auf der durch das Substrat definierten Ebene zu steht kommt. Hierzu wird vor dieser Anordnung die Verbindungseinrichtung in einem Biegebereich abgewinkelt
Es ist weiterhin vorteilhaft, wenn nach der Anordnung zu dem Gehäuse die isolierende Folie mit mindestens einer zweiten Leiterbahn das Gehäuse überragt. Ebenso vorteilhaft ist es, wenn das Lastanschlusselement vor der gemeinsamen Anordnung mit der Verbindungseinrichtung zu dem Gehäuse des Leistungshalbleitermoduls an der Sollbiegestelle abgewinkelt wird. Somit kommt die Kontaktfläche des Lastanschlusselements zur Verbindung mit der Verbindungseinrichtung auf der Außenseite des ersten Schenkels zu liegen. Weiterhin vorteilhaft ist es wenn der zweite Schenkel des Lastanschlusselements eine Ausnehmung für eine Schraubendurchführung aufweist und dieser zweite Schenkel parallel zum Substrat angeordnet wird.

Die Erfindung wird anhand von Ausführungsbeispielen in Verbindung mit den Fig. 1 bis 5 näher erläutert.

Fig. 1 zeigt einen Schritt des erfindungsgemäßen Herstellungsverfahrens eines Leistungshalbleitermoduls.

Fig. 2 zeigt eine grundlegende Ausgestaltung des erfindungsgemäßen Leistungshalbleitermoduls.

Fig. 3 zeigt eine zweite erfindungsgemäße Ausgestaltung des Leistungshalbleitermoduls.

Fig. 4 zeigt eine dreidimensionale Darstellung des zweiten erfindungsgemäßen Leistungshalbleitermoduls.

Fig. 5 zeigt eine Variation der zweiten Ausgestaltung des erfindungsgemäßen Leistungshalbleitermoduls.

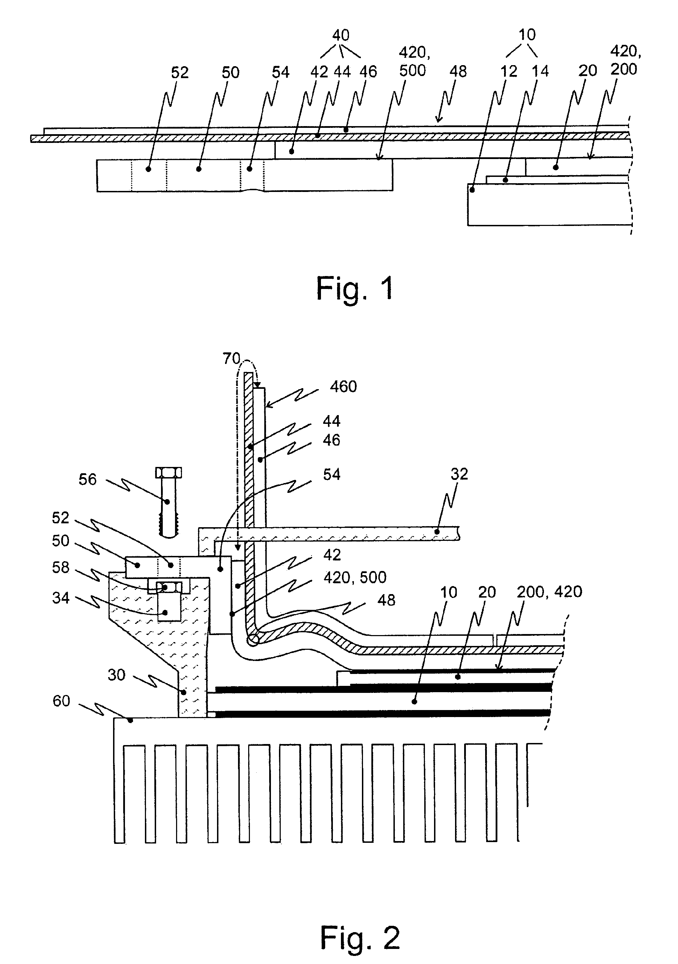

Fig. 1 zeigt einen Schritt des erfindungsgemäßen Herstellungsverfahrens eines Leistungshalbleitermoduls. Dargestellt sind ein Substrat (10) mit einem Isolierstoffkörper (12) und hierauf angeordneten Leistungshalbleiterbauelementen (14), sowie ein Lastanschlusselement (50). Das Lastanschlusselement (50) ist hier ausgebildet als ein planer Metallformkörper mit einer Sollbiegestelle (54) zur späteren Ausbildung einer winkelförmigen Ausgestaltung des Lastanschlusselements (50).

Das Leistungshalbleiterbauelement (20) und das noch plane Lastanschlusselement (50) werden mittels einer Verbindungseinrichtung (40) elektrisch leitend miteinander verbunden. Diese Verbindungseinrichtung (40) weist eine Schichtfolge von einer ersten elektrisch leitenden strukturierten Metallfolie (42), einer elektrisch isolierenden Folie (44) und einer zweiten elektrisch leitenden strukturierten Metallfolie (46) auf. Hierbei bilden die jeweiligen Strukturierungen erste und zweite Leiterbahnen aus den jeweiligen Metallfolien aus. Die elektrisch leitenden Verbindungen von jeweiligen dritten Kontaktflächen (200) des Leistungshalbleiterbauelements bzw. zweiten Kontaktflächen (500) des Lastanschlusselements (50) mit zugeordneten ersten Kontaktflächen (420) der ersten Leiterbahn (42) der Verbindungseinrichtung (40) werden mittels einer Drucksinterverbindung ausgebildet. Ebenfalls dargestellt ist ein Biegebereich (48, vgl. auch Fig. 2) an dem die Verbindungseinrichtung vor Anordnung mit dem Gehäuse abgewinkelt wird.

Erfindungsgemäß überragt die isolierende Folie (44) der Verbindungseinrichtung (40) alle ersten Leiterbahnen (42) in Richtung vom Substrat (10) zum Rand der Folie (44) hin derart, dass von ersten (42) zu zweiten Leiterbahnen (46) die bis zu oder nahe an diesem Rand reichen ausreichend Abstand ist, um Luft- und Kriechstrecken zur elektrischen Sicherheit einzuhalten.

Fig. 2 zeigt eine grundlegende Ausgestaltung des erfindungsgemäßen und erfindungsgemäß hergestellten Leistungshalbleitermoduls. Dargestellt ist ein isolierendes Substrat (10), wie es in verschiedenen Ausgestaltungen grundsätzlich aus der Anwendung in Leistungshalbleitermodulen bekannt ist. Dieses weist auf seiner dem Inneren des Leistungshalbleitermoduls zugewandten Oberfläche eine Mehrzahl von Verbindungsbahnen (14, vgl. Fig. 1) auf. Auf diesen Verbindungsbahnen (14) sind Leistungshalbleiterbauelemente (20) angeordnet und vorzugsweise stoffschlüssig mittels Lot- oder Sinterverbindungen mit den Verbindungsbahnen verbunden.

Der weiteren Ausbildung der schaltungsgerechten internen Verbindungen der Leistungshalbleiterbauelemente (20) dient die Verbindungseinrichtung (40, vgl. Fig. 1), die ihrerseits aus einer Schichtfolge mit einer ersten elektrisch leitenden strukturierten Metallfolie (42), einer elektrisch isolierenden Folie (44) und einer zweiten elektrisch leitenden strukturierten Folie (46) besteht. Falls notwendig kann dies Schichtfolge alternierend fortgeführt werden. Die jeweiligen Strukturierungen der ersten und zweiten Metallfolien bilden erste und zweite jeweils elektrisch voneinander isolierte Leiterbahnen aus.

Diese Leiterbahnen (42, 46) dienen nicht nur der internen schaltungsgerechten Verbindung innerhalb des Leistungshalbleitermoduls (20) sondern bilden auch Teile der externen Anschlusselemente aus. Hierzu weist die Verbindungseinrichtung (40) mindestens einen Bereich auf der nicht parallel zur Substratoberfläche angeordnet ist. Dieser Bereich steht vorzugsweise senkrecht auf der durch die Substratoberfläche gebildeten Ebene und weist auf ersten Leiterbahnen (42) erste Kontaktflächen (420) zur Verbindung mit zweiten Kontaktflächen (500) von Lastanschlusselementen (50), von denen nur eines dargestellt ist, auf.

Dieses Lastanschlusselement (50) besteht aus einem winkelförmigen Metallformteil, dessen erster Schenkel mit seiner Außenseite die die Kontaktfläche (500) bildet auf der ersten Kontaktfläche (420) der ersten Leiterbahn (42) der Verbindungseinrichtung (40) angeordnet ist und dessen zweiter Schenkel eine Ausnehmung (52) für eine Schraubendurchführung (56) aufweist. Dieser zweite Schenkel ist parallel zum Substrat (10) angeordnet. Die dem Lastanschlusselement (50) zugeordnete ersten Leiterbahn (42) reicht bis an die durch die dem Substrat (10) abgewandte Oberfläche des zweiten Schenkels des Lastanschlusselements (50) gebildete Ebene, heran, wobei hier geringe Toleranzen unschädlich sind, solange die notwendigen Luft- und Kriechstrecken (70) eingehalten werden.

Die isolierende Folie (44) der Verbindungseinrichtung (40) wie auch die zweiten Leiterbahnen (46) überragen diese Ebene, wobei die zweiten Leiterbahnen (46) hier kein Lastpotential führen, sondern Steuer- und / oder Sensorpotentiale. Diese Erstreckung über die genannte Ebene hinaus ist dergestalt ausgebildet, dass durch die isolierende Folie die notwendigen Luft- und Kriechstrecken (70) zur Gewährleistung der elektrischen Sicherheit des Leistungshalbleitermoduls zwischen Last- und Steuerpotential ausgebildet werden.

Das Gehäuse (30) des Leistungshalbleitermoduls ist ebenfalls schematisch dargestellt, wobei diese das Substrat (10) vollständig und die Lastanschlusselemente (50) derart umschließt, dass eine externe Kontaktierung mittels einer Schraubverbindung (56, 58) gestattet ist. Erfindungsgemäß ragen die isolierende Folie (44) und die zweiten Leiterbahnen (46) aus dem Gehäuse (30) heraus um dort externe Hilfsanschlusselemente auszubilden.

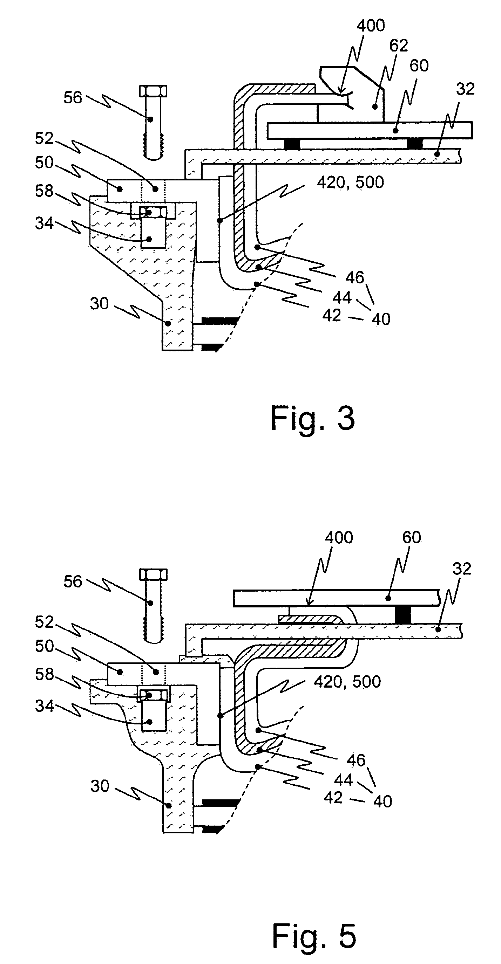

Fig. 3 zeigt eine zweite erfindungsgemäße Ausgestaltung des Leistungshalbleitermoduls. Das Leistungshalbleitermodul wird wiederum ausgebildet aus den beiden wesentlichen Komponenten, dem Gehäuse (30) und dem Substrat (10) mit Leistungshalbleiterbauelementen (20), Verbindungseinrichtung (40) und Lastanschlusselementen (50). Hierzu wird in einem ersten Schritt der Herstellung diese zweite Komponente beispielhaft mittels des Verfahrensschritts gemäß Fig. 1 ausgebildet. Allgemein erfolgt dies vorzugsweise durch Lot- und / oder Drucksinterverbindungen. Hierbei wird in einem ersten Schritt die Verbindungseinrichtung (40) mit den Leistungshalbleiterbauelementen (20) verbunden und in einem nächsten Schritt die Verbindung zwischen den Leistungshalbleiterbauelementen (20) und dem Substrat (10) und gleichzeitig die Verbindung zwischen den Lastanschlusselementen (50) und der Verbindungseinrichtung (40), ausgebildet. Alternativ ist eine beliebige sequenziell Ausbildung aller einzelnen Verbindungen auch mittels unterschiedlicher Technologien möglich.

Vor der Anordnung der zweiten Komponente wird noch das Lastanschlusselement (50) entlang der Sollbiegestelle (54, vgl. Fig. 1) in die winkelige Form gebracht und anschießend die Komponente mit dem Gehäuse (30) zusammengefügt. Erfindungsgemäß ragt ein Teil der Verbindungseinrichtung (40), nämlich ein Teil der isolierenden Folie (44) und zweiter Leiterbahnen (46) aus dem Gehäuse (30) heraus. Dort bildet das Ende der Verbindungseinrichtung (40) Hilfskontaktanschlussflächen (46) für einen ein- oder mehrpoligen Steckkontakt aus, der in einem Steckverbinder (62) einer externen Leiterplatte (60) anordenbar ist. Die Flexibilität der Verbindungseinrichtung (40) bildet quasi selbsttätig eine Zugkraftunterbrechung aus, wodurch eine sichere Steckverbindung gewährleistet ist. Zusätzlich könnte ein mäanderförmiger Verlauf der Verbindungseinrichtung (40) außerhalb des Gehäuses (30) vorgesehen werden. Der Steckverbinder (62) zur Verbindung der Steuer- und / oder Sensorsignale ist vorteilhafterweise auf der externen Leiterplatte mit Treiberschaltungen angeordnet, die ihrerseits beabstandet zum Gehäuse (30) des Leistungshalbleitermoduls und parallel zu dessen Substrat (10) anordenbar ist.

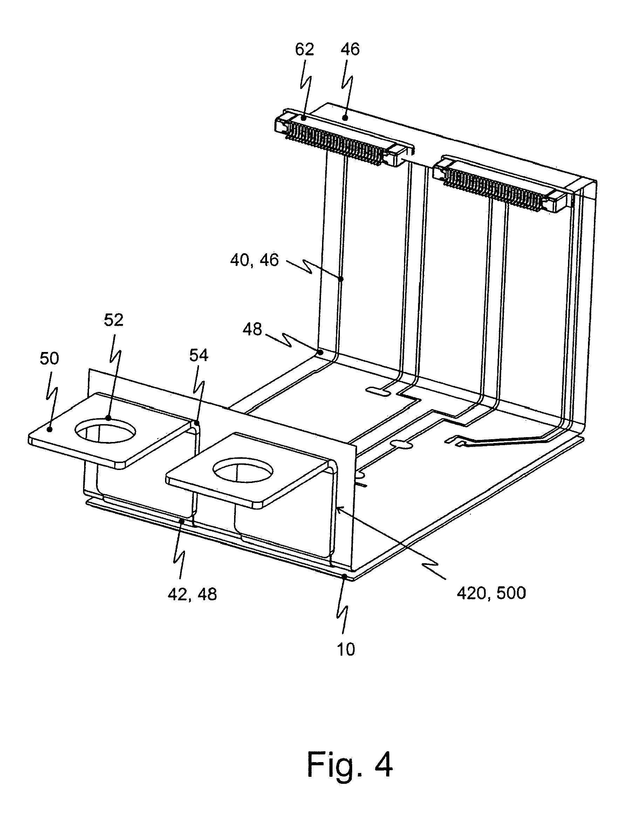

Fig. 4 zeigt eine dreidimensionale Darstellung des zweiten erfindungsgemäßen Leistungshalbleitermoduls. Hierbei ist der Verlauf der unter Fig. 3 beschriebenen ersten und zweiten Leiterbahnen (42, 46) nochmals deutlich ersichtlich.

Fig. 5 zeigt eine Variation der zweiten Ausgestaltung des erfindungsgemäßen Leistungshalbleitermoduls. Diese unterscheidet sich dahingehend, dass die Hilfskontaktanschlussflächen (460) der zweiten Leiterbahnen (46) durch ein 180° Kröpfung der Verbindungseinrichtung (40) auf der dem Gehäuse (30) abgewandten Seite des aus diesem herausragenden Abschnitts der Verbindungseinrichtung (40) zu liegen kommt. Hierdurch ist eine elektrische Verbindung zu einer darüber angeordneten externen Leiterplatte (60) einfach möglich, indem über die Leiterplatte (60) Druck (64) auf die Verbindung zu den zweiten Leiterbahnen (46) ausgeübt wird. Hierzu bildet das Gehäuse (32) ein Widerlager für diese Druckeinleitung aus.

Zudem wird das Gehäuse (30) hier erst bei der Herstellung des Leistungshalbleitermoduls ausgebildet indem mittels eines Spritzverfahrens zumindest das Lastanschlusselement (50) umschlossen wird. Somit kann auf ein vorgefertigtes Gehäuse verzichtet werden.

## Patentansprüche

1. Verfahren zur Herstellung eines Leistungshalbleitermoduls mit einem Substrats (10), einer Verbindungseinrichtung (40) und einer Mehrzahl von Lastanschlusselementen (50), wobei auf einer Leiterbahn (14) des Substrats (10) mindestens ein Leistungshalbleiterbauelement (20) angeordnet und schaltungsgerecht mittels der Verbindungseinrichtung (40) mit mindestens einem Lastanschlusselement (50) verbunden ist und wobei die Verbindungseinrichtung (40) Hilfskontaktanschlussflächen (460) aufweist die mit einer externen Leiterplatte (60) verbindbar sind **gekennzeichnet durch** die wesentlichen Herstellungsschritte:
• Bereitstellung eines Substrats (10) und einer Verbindungseinrichtung (40) mindestens gebildet aus einer Schichtfolge mit einer ersten elektrisch leitenden strukturierten Metallfolie (42), einer elektrisch isolierenden Folie (44) und einer zweiten elektrisch leitenden strukturierten Metallfolie (46), wobei die jeweiligen Strukturierungen erste und zweite Leiterbahnen aus den jeweiligen Metallfolien ausbilden;
• gleichzeitiges oder sequenzielles stoffschlüssiges Verbinden jeweiliger erster Kontaktflächen (420) der ersten Leiterbahnen (42) mit mindestens einer zweiten Kontaktfläche (200) eines Leistungshalbleiterbauelements (20) und mindestens einer dritten Kontaktfläche (500) eines Lastanschlusselements (50);
• Anordnen des Verbunds aus mindestens einem Leistungshalbleiterbauelement (20) einer Verbindungseinrichtung (40) und Lastanschlusselementen (50) zu einem Gehäuse (30) des Leistungshalbleitermoduls.

2. Verfahren nach Anspruch 1, wobei
ein jeweiliger Abschnitt der Verbindungseinrichtung (40) auf dem die Kontaktflächen (200, 420) mit den Lastanschlusselementen (20) angeordnet sind bei der Anordnung zu dem Gehäuse (30) senkrecht auf der durch das Substrat (10) definierten Ebene zu steht kommt und hierzu vorher die Verbindungseinrichtung (40) in einen Biegebereich (48) abgewinkelt wird.

3. Verfahren nach Anspruch 1 oder 2, wobei
die isolierende Folie (44) der Verbindungseinrichtung (40) alle ersten Leiterbahnen in Richtung vom Substrat zum Rand der Folie (44) hin derart überragt, dass zu zweiten Leiterbahnen (46) der zweiten Folie die bis zu oder nahe an diesem Rand reichen ausreichend Abstand (70) ist, um Luft- und Kriechstrecken zur elektrischen Sicherheit einzuhalten und wobei nach der Anordnung zu dem Gehäuse (30) die isolierende Folie (44) mit mindestens einer zweiten Leiterbahn (46) das Gehäuse überragt.

4. Verfahren nach Anspruch 1, wobei
mindestens ein Lastanschlusselement (50) als ein winkelförmiges Metallformteil ausgebildet ist, dessen Kontaktfläche (500) zur Verbindung mit der Verbindungseinrichtung (40) auf der Außenseite des ersten Schenkels angeordnet ist und dessen zweiter Schenkel eine Ausnehmung (52) für eine Schraubendurchführung (56) aufweist und dieser zweite Schenkel parallel zum Substrat (10) angeordnet ist und die Winkelform vor der Anordnung im Substrat ausgebildet wird.

5. Leistungshalbleitermodul mit einem Substrats (10), einer Verbindungseinrichtung (40) und einer Mehrzahl von Lastanschlusselementen (50), wobei auf einer Leiterbahn (14) des Substrats (10) mindestens ein Leistungshalbleiterbauelement (20) angeordnet und schaltungsgerecht mittels der Verbindungseinrichtung (40) aus einer Schichtfolge mit einer ersten elektrisch leitenden und strukturierten Metallfolie (42), einer elektrisch isolierenden Folie (44) und einer zweiten elektrisch leitenden und strukturierten Folie (46), wobei die jeweiligen Strukturierungen erste und zweite Leiterbahnen aus den jeweiligen Metallfolien ausbilden, mit mindestens einem Lastanschlusselement (50) verbunden ist, wobei mindestens eine erste Leiterbahn (42) einer Kontaktfläche (420) aufweist, die mit einem Lastanschlusselement (50) stoffschlüssig verbunden ist und wobei die Verbindungseinrichtung (40) Hilfskontaktanschlussflächen (460) aufweist die mit einer externen Leiterplatte (60) verbindbar sind.

6. Leistungshalbleitermodul nach Anspruch 5, wobei
der Abschnitt der Verbindungseinrichtung (40) auf dem die Kontaktflächen (420) zu den Lastanschlusselementen (50) angeordnet sind senkrecht auf der durch das Substrat (10) definierten Ebene steht.

7. Leistungshalbleitermodul nach Anspruch 6, wobei
die isolierende Folie (44) der Verbindungseinrichtung alle ersten Leiterbahnen (42) in Richtung vom Substrat (10) zum Rand der Folie (44) hin derart überragt, dass zu zweiten Leiterbahnen (46) der zweiten Folie die bis zu diesem Rand reichen ausreichend Abstand (70) ist, um Luft- und Kriechstrecken zur elektrischen Sicherheit einzuhalten und wobei dieser Teil der isolierenden Folie (44) mit mindestens einer zweite Leiterbahn (46) das Gehäuse (30) überragt.

8. Leistungshalbleitermodul nach Anspruch 5, wobei
mindestens ein Lastanschlusselement (50) als ein winkelförmiges Metallformteil ausgebildet ist, dessen Kontaktfläche (500) zur Verbindung mit der Verbindungseinrichtung (40) auf der Außenseite des ersten Schenkels angeordnet ist und dessen zweiter Schenkel eine Ausnehmung (52) für eine Schraubendurchführung (56) aufweist und dieser zweite Schenkel parallel zum Substrat (10) angeordnet ist.
